# DEMANDE DE BREVET EUROPEEN

(11) **EP 3 171 575 A1**
(43) Date de publication de la demande: **24.05.2017**
(21) Numéro de dépôt: 16199354.8
(22) Date de dépôt: 17.11.2016
(51) Int. Cl.: H04L 29/08

(54) **PROCEDE DE GENERATION D'UN ENSEMBLE DE DONNEES DEFINISSANT UNE MESSAGE POUR UNE APPLICATION CONTRAINTE**

(30) Priorité: 18.11.2015 FR 1502418
(71) Demandeur: BULL SAS, 78340 Les Clayes sous Bois (FR)
(72) Inventeur: RICHARD, Julien, 13127 Vitrolles (FR); ROMAN, Alexandre, 83400 Hyères (FR)
(74) Mandataire: Cabinet Camus Lebkiri

(57) **Abrégé**

Le procédé de génération d'un ensemble de données définissant un message (MES) comporte :
▪ Une définition d'un premier descripteur (DESCR_1) d'un ensemble de messages (MES), chaque message (MES) comportant un ensemble d'attributs comportant chacun un type réduit (TYP_RED), ledit descripteur (DESCR_1) décrivant également l'ensemble des types réduits, chaque type réduit (TYP_RED) étant encodé à partir d'un type d'origine (TYP_ORI) ;
▪ Une transformation du premier descripteur (DESCR_1) en une librairie de messages préconfigurés (MES_H) définissant un référentiel donné (REF_H) ;
▪ Une instanciation d'un message (MES_H) du référentiel (REF_H) pour générer un ensemble de données sur une mémoire (M).

## Description

### DOMAINE

Le domaine de l'invention concerne la génération de données définissant un message dont la taille est optimisée pour des applications contraintes. Plus particulièrement, l'invention se rapporte à la génération de messages de commandement au sein d'un système d'information tactique au sein duquel les débits de transmissions sont contraints. Plus particulièrement, l'invention se rapporte aux opérations visant à minimiser l'espace physique de données nécessaire à l'édition de message ainsi qu'à la mise en oeuvre d'un environnement permettant de définir de tels messages et de les instancier.

### ETAT DE L'ART

Dans le domaine des télécommunications tactiques, notamment déployées dans les corps d'états ou dans des organisations devant normaliser leurs échanges, la définition des systèmes de messagerie doit répondre à des contraintes plus fortes que celles des messageries classiques utilisées dans les logiciels grand public. Les possibilités de définir des objets librement sont réduites dans la mesure où cette liberté peut conduire à des erreurs d'appréciation ou encore des différences d'implémentation de nomenclatures ou de normes utilisées par différentes organisations communiquant ensemble. Il est recommandé de limiter ou de contraindre les contrôles de saisie dès lors qu'une information doit être transmise dans un formaliste prédéfini de manière certaine.

Enfin, selon le contexte de transmission de données, les utilisateurs de systèmes de messagerie n'ont pas accès en permanence à un débit élevé de données. C'est par exemple le cas lors d'une opération au sein de laquelle des hommes sont amenés à se rendre dans des lieux sans infrastructure de communication pour effectuer des missions locales pendant une durée donnée. D'autres situations impliquent une allocation de débit limité, or dans ces contextes il est nécessaire que des communications puissent être établies à minima pour transmettre un minimum d'informations nécessaire pour réaliser la mission.

Il existe donc un besoin de définir une solution permettant de transmettre des données entre différentes entités qui soit compatible d'un débit limité. Or un problème est qu'une transmission de certains messages d'un référentiel donné nécessite de disposer de certaines ressources minimales et d'une bande passante minimale. C'est par exemple le cas, lorsqu'une position définie dans un référentiel donné est codée sur 16 octets, alors qu'une position simplement codée sur 2 octets suffirait à informer une tierce partie de ladite position à qui l'on souhaite lui communiquer.

Une solution consiste à changer le référentiel de messagerie pour limiter le volume de données à transmettre. Dans cette solution, les objets, c'est-à-dire les messages, les attributs et les types des attributs, sont redéfinis en taille d'octets pour être compatibles d'une contrainte de débit. Or un premier problème devient l'interopérabilité entre les différentes entités de communication. Un second problème est d'assurer une pérennité d'évolution d'un nouveau référentiel.

Lorsqu'un système de messagerie implique une modification du codage des messages, il est impératif que toutes les entités puissent recevoir et décoder les messages reçus et émettre des messages qui puissent être interprétés par ce système de messagerie.

En outre, la définition de nouveaux types ou de messages optimisés imposent une grande connaissance de la structure des messages et une définition laborieuse à intégrer lorsque cette dernière est destinée à évoluer.

Il existe donc un besoin de définir un moyen sécurisé d'un ensemble de messages destiné à des applications contraintes, c'est-à-dire avec une optimisation de la taille de chaque message.

### RESUME DE L'INVENTION

L'invention vise à pallier les inconvénients précités. Notamment, l'invention permet de générer une librairie de messages optimisé en taille d'octets et constituant un référentiel de messagerie qui garantissent une pérennité dans l'évolution de ce référentiel.

L'invention permet en outre de définir des types codés pour être optimisés afin de réduire le volume d'espace nécessaire à la transmission d'un message selon une contrainte de débit donnée. En outre, l'invention assure une compatibilité d'un système de messagerie recevant un message optimisé.

Un objet de l'invention se rapporte à un procédé de génération d'un ensemble de données définissant un message. Il comporte :
▪ Une définition d'un premier descripteur d'un ensemble de messages, chaque message comportant un ensemble d'attributs comportant chacun un type réduit, ledit descripteur décrivant également l'ensemble des types réduits, chaque type réduit étant encodé à partir d'un type d'origine;
▪ Une transformation du premier descripteur en une librairie de messages préconfigurés définissant un référentiel donné ;
▪ Une instanciation d'un message du référentiel pour générer un ensemble de données sur une mémoire.

Selon un mode de réalisation, la définition du premier descripteur comprend un ensemble de règles définissant des gammes de valeurs d'un type réduit, lesdites gammes de valeurs étant incluses dans les gammes de valeurs définissant un type d'origine.

Selon un mode de réalisation, un codage d'un type réduit comprend une réduction du nombre d'octets codant un type d'origine.

Selon un mode de réalisation, le codage d'un type réduit comprend la sélection d'un autre type que le type d'origine, ledit autre type comprenant un nombre d'octets inférieur au nombre d'octets du type d'origine.

Selon un mode de réalisation, le codage d'un type réduit comprend une troncature d'un type d'origine.

Selon un mode de réalisation, le codage d'un type réduit comprend une extraction d'une liste de valeurs d'un type d'origine.

Selon un mode de réalisation, la transformation du premier descripteur comprend :
▪ la génération d'un second descripteur ;
▪ la compilation du second descripteur pour générer :
   o une librairie de messages préconfigurés ;
   o une fonction pour instancier un message sélectionné.

Un autre objet de l'invention concerne un système de messagerie pour la mise en oeuvre du procédé de l'invention. Le système comprend :
▪ au moins une mémoire pour le stockage des données du premier descripteur, des données du second descripteur, des messages préconfigurés de la librairie et des données générées par le procédé ;
▪ un calculateur pour effectuer les opérations de transformation du premier descripteur en une librairie de messages préconfigurés;
▪ un calcul d'au moins une instance d'un message préconfiguré.

### BREVE DESCRIPTION DES FIGURES

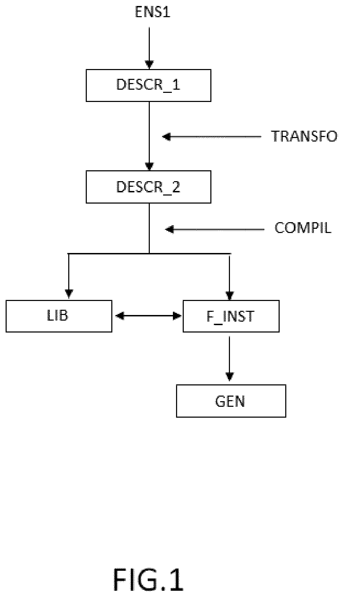

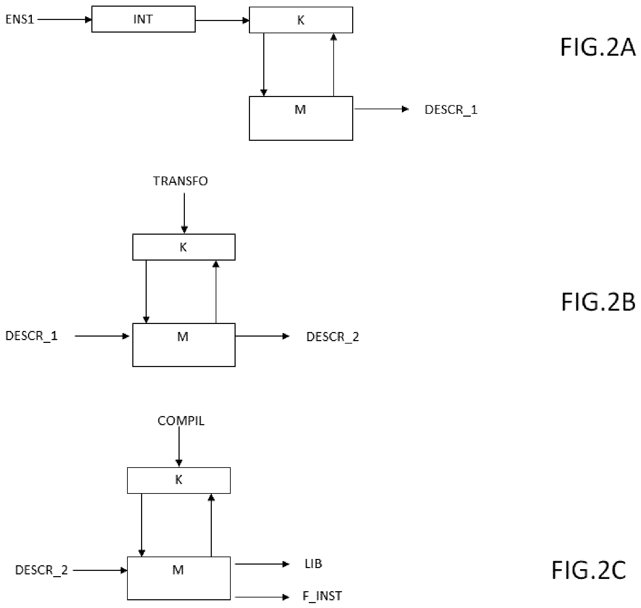

D'autres caractéristiques et avantages de l'invention ressortiront à la lecture de la description détaillée qui suit, en référence aux figures annexées, qui illustrent :
▪ figure 1 : les principales étapes du procédé de l'invention ;
▪ figure 2 : les principaux composants du système de l'invention pour mettre en oeuvre le procédé de l'invention.

### DESCRIPTION

L'invention se rapporte à la génération d'une librairie de messages d'un référentiel donné pour son usage dans une messagerie. Lesdits messages sont préconfigurés pour optimiser l'espace de données nécessaire à décrire un objet.

L'invention se rapporte donc à la génération d'un ensemble de données sur une mémoire M définissant une instanciation d'un message ainsi préconfiguré.

L'invention a l'avantage de mettre à disposition un ensemble de messages préconfigurés à un utilisateur souhaitant définir un système de messagerie ou à un utilisateur souhaitant définir un message. Une interface permet de déterminer un message préconfiguré et de l'instancier simplement. Chacun des messages est défini de manière optimale avec un minimum d'octets permettant de définir des valeurs d'un attribut.

L'invention permet de faciliter la mise en oeuvre d'une messagerie dont les objets doivent occuper un minimum d'espace utile dans l'objectif d'être transmis dans un environnement radio dont le débit est limité. A cet effet, il est nécessaire de définir des objets ayant un minimum d'octets. Ces objets sont, par exemple, définis à partir d'objets plus complets définis sur un plus grand nombre d'octets.

Un objet comporte au moins un attribut qui est défini par un type donné. Un objet optimisé en taille comprend des attributs définis par des types optimisé en taille. On parle d' « optimisation en taille », lorsqu'il y a une réduction du nombre d'octets définissant un élément d'un référentiel donné vers un référentiel de messages optimisés, appelé référentiel REF H dans l'invention.

Un type optimisé lorsqu'il est généré à partir d'un type d'origine TYP_ORI est appelé « type réduit », TYP_RED. Selon un mode de réalisation, l'invention comporte un ensemble de règles permettant de générer automatiquement des types réduits TYP_RED à partir de types d'origines TYP_ORI.

### Exemple du type « position »

A titre d'exemple, l'objet définissant une « position » peut être défini par un type d'origine ayant une latitude, une longitude et une altitude.

Un premier exemple de génération d'un type réduit POSITION_RED à partir d'un type d'origine POSITION_ORI est de supprimer le paramètre de l'altitude pour définir un objet dont l'altitude ne sera pas exploitée.

Un second exemple de génération d'un type réduit POSITION_RED à partir d'un type d'origine POSITION_ORI est de limiter le nombre de décimales définissant une latitude et/ou une longitude et/ou une altitude permettant ainsi de réduire le nombre d'octets définissant chaque paramètre du type POSITION_RED.

Un troisième exemple de génération d'un type réduit POSITION_RED à partir d'un type d'origine POSITION_ORI est de limiter la plage de valeurs possibles des valeurs prises par chaque paramètre de manière à permettre un meilleur encodage d'une position sur une plage de valeurs réduite.

Un autre exemple peut être une combinaison des précédents exemples.

### Perte d'informations

La génération d'un type réduit TYP_RED à partir d'un type d'origine TYP_ORI implique généralement une perte d'informations. L'invention permet de disposer d'un certain nombre de messages préconfigurés chacun permettant de réaliser un compromis entre :
▪ d'une part, une transmission d'une information fiable pour un niveau de précision donné et ;
▪ d'autre part, une optimisation du débit des données à transmettre pour assurer que la transmission du message soit réalisée de manière certaine.

D'autres objets comportant des types réduits TYP_RED peuvent être définis de sorte à diminuer la taille des messages à transmettre. A titre d'exemple, un type réduit « DATE_RED » peut être défini à partir d'un type d'origine « DATE_ORI » définissant une date avec une précision d'une milliseconde. Le type « DATE_RED » peut être défini avec une précision de l'ordre de la seconde. La génération du type réduit DATE_RED peut être obtenue par troncature du type d'origine DATE_ORI.

La figure 1 représente les principales étapes du procédé de l'invention.

### Descripteur de données XML

Dans un premier temps, un ensemble de données, noté ENS1, est décrit dans un descripteur DESCR_1. Le descripteur DESCR_1 comprend des champs permettant de définir les objets permettant de composer les différents éléments d'un message, leurs attributs et le type de chaque attribut. Un calculateur K peut être utilisé pour définir notamment les types réduits à partir des types d'origines. Selon un mode de réalisation et selon la compression de données souhaitée, c'est-à-dire la réduction du nombre d'octets que l'on souhaite obtenir d'un message, le calculateur K permet de définir des types réduits TYP_RED de différentes natures.

La configuration d'une telle compression peut dépendre :
▪ d'un référentiel donné souhaité de messages optimisés ou encore ;
▪ d'une mission particulière imposant des contraintes spécifiques de débit de transmission impliquant, par exemple, la définition de nouveaux messages dans le référentiel.

Le passage d'un type d'origine TYP_ORI à un type réduit TYP_RED peut être réalisé de différentes manières comme par exemple par une opération de troncature de données et/ou une opération de réduction d'un ensemble de valeurs énumérées et/ou une opération de changement de type, etc.

Un type d'origine TYP_ORI peut également être utilisé pour définir différents types réduits TYP_RED qui seront utilisés selon le message qui sera instancié.

Selon un premier exemple, un message MES indiquant une consigne d'atterrissage d'un aéronef à une position donnée devra comporter l'altitude de la position. En revanche, la position peut être définie avec une précision de l'ordre du centimètre et non du millimètre.

Selon un second exemple, un message MES indiquant un point de rencontre ne nécessite par la définition d'une altitude. La latitude et la longitude suffise à définir un point de rencontre.

Ainsi différents objets peuvent être définis avec différents attributs ayant des types adaptés à la description de l'objet en question. Selon le contexte et le message à générer, les types réduits TYP_RED définissent les différents attributs d'un objet.

Avantageusement, le descripteur DESCR_1 peut être un fichier dont le format est XSD ou XML. On précise que l'acronyme anglo-saxon « XSD » désigne « XML Schema Documentation ». On rappelle que l'acronyme « XML » désigne « Extensible Markup Language ».

D'autres formats de fichiers peuvent être employés selon le procédé de l'invention.

Un avantage de l'utilisation d'un format tel que XML est que lors de la lecture des messages MES du référentiel REF H transitant sur un canal de communication, une opération d'interprétation du message MES peut être engagée de sorte à générer un affichage du contenu dans une interface de visualisation.

Les données des messages, des objets et des types du descripteur DESCR_1 permettent de définir un référentiel noté REF H. Ce descripteur DESCR_1 permet de maintenir à jour le référentiel REF H, par exemple lors de l'édition de nouveaux objets, de nouveaux types ou de nouveaux messages à décrire.

Ainsi, un descripteur de données permet de décrire les différents messages pouvant être utilisés dans une messagerie, les attributs de chaque message et chaque type des attributs de ces messages.

### Transformation

L'invention comprend une étape de transformation des données du premier descripteur DESCR_1 en une librairie LIB de messages préconfigurés MES. La librairie LIB de messages préconfigurés permet de définir les messages encodés dans le référentiel REF H dans un état où chacun d'eux est prêt à être instancié simplement par une commande unique d'un opérateur. Ainsi, lors de la configuration d'une messagerie, il n'est pas nécessaire d'encoder de nouveaux types réduits directement dans l'interface de messagerie.

Cette transformation comprend deux temps.

Dans un premier temps, la transformation de l'invention comprend une étape permettant, à partir des données définissant les objets des messages dans un premier descripteur DESCR_1, de générer des données décrivant ces mêmes objets dans un second descripteur de données DESCR_2.

On entend par « objet » d'un message, soit le message lui-même comportant un ensemble d'attributs et dont chaque attribut a un type, soit un élément permettant de définir une partie d'un message.

Les transformations peuvent être réalisées grâce à un ensemble de règles de transformation permettant de passer d'un fichier descripteur à un autre. Ces règles peuvent être définies de sorte à organiser et structurer selon une logique prédéfinie les fichiers descripteurs.

Dans un second temps, à partir du second descripteur DESCR_2, la transformation de l'invention comprend une étape permettant de générer :
▪ une librairie LIB de messages préconfigurés, notés MES_H ;
▪ une fonction d'instanciation F_INST d'un message MES de ladite librairie LIB.

Ce second temps est également appelé COMPIL dans la figure 1.

L'ensemble des messages H constitue une partie du référentiel REF_H dans laquelle les messages peuvent être directement utilisés par une opération d'instanciation selon un contexte donné.

### Génération de données d'un message optimisé

Lorsqu'une instanciation d'un message préconfiguré MES de la librairie LIB est engagée, un ensemble de données est généré pour être stocké sur une mémoire M. L'étape de génération de ces données est notée GEN dans la figure 1. Il peut s'agir alternativement d'une réservation d'espace sur la mémoire M afin de stocker le message lorsque ce dernier sera généré à partir de la messagerie.

### Codage/décodage

Lorsqu'un utilisateur souhaite générer un message dans le référentiel REF_H, il peut instancier un message avec des paramètres. Le procédé de l'invention permet notamment différentes possibilités dont :
▪ évaluer la taille en octets d'un message MES du référentiel REF H;
▪ vérifier que les types d'un objet sont bien définis dans le référentiel REF H lors de la définition d'un nouveau message ;
▪ coder un message d'un autre référentiel moins contraint par une opération de compression des données, c'est-à-dire par une réduction du nombre d'octets codant le message.

En outre, selon un mode de réalisation de l'invention, lors de la réception d'un message MES par une interface de communication, la fonction d'instanciation F_INST permet de décoder un message en réception pour récupérer les paramètres du message reçu. Une opération de comparaison du message décodé reçu avec les messages MES_H de la librairie LIB permet de récupérer les paramètres du message reçu.

Le procédé de l'invention permet donc :
▪ d'une part, d'interpréter des messages transmis pour les afficher dans une interface grâce à un premier descripteur DECSR_1 ;
▪ d'autre part, de permettre de générer une librairie LIB de messages préconfigurés.

La librairie LIB de messages préconfigurés MES permet d'éviter notamment les erreurs d'encodage de type réduit TYP_RED. En effet, l'encodage d'un type nécessite une manipulation de chaque octet et une configuration particulièrement sensible lors de la définition d'un objet ou d'un message. Grâce au procédé de l'invention, une interopérabilité est assurée entre les différentes messageries d'un même système. En outre, la définition d'un référentiel REF_H est pérenne et évolutif.

### Description des composants du système

La figure 2A représente, selon un mode de réalisation, les composants du système de l'invention pour permettre la génération d'un descripteur DESCR_1. L'ensemble de données ENS1 peut être acquis par une interface de gestion de données ou encore par la réception d'un fichier ou encore par la lecture d'un fichier stocké sur une mémoire M. Lorsque des opérations de génération d'un type réduit TYP_RED à partir d'un type d'origine TYP_ORI sont automatiquement réalisées, un calculateur K permet d'effectuer les différentes opérations de compression, comme par exemple une troncature d'un type.

Les données décrivant les objets dans le référentiel REF_H au moyen du descripteur DESCR_1 sont stockées dans une mémoire M. La mémoire M peut être celle précédemment citée ou une autre mémoire.

La figure 2B représente, selon un mode de réalisation de l'invention, les composants du système de l'invention pour permettre la génération d'un second descripteur DESCR_2. La transformation des données du premier descripteur DESCR_1 dans un second descripteur DESCR_2 peut être réalisée au moyen d'un calculateur K. Ce calculateur peut être identique ou différent que le précédent calculateur. Les transformations peuvent être réalisées grâce à un ensemble de règles de transformation permettant de passer d'un fichier descripteur à un autre.

L'intérêt de l'usage des deux descripteurs DESCR_1 et DECSR_2 est qu'ils réalisent chacun une fonction donnée. Le premier descripteur DESCR_1 permet notamment une interprétation graphique des messages MES transitant sur une voie de communication, alors que le second descripteur DESCR_2 permet la génération d'une librairie de messages pouvant être chacun instancié. En outre, le premier descripteur DESCR_1 peut servir de référentiel au message H lors que l'on souhaite faire évoluer le référentiel, par exemple en définissant de nouveaux messages. Le second descripteur DESCR_2 permet de mettre à jour la librairie grâce à la transformation de l'invention TRANSFO lorsque la messagerie est déployée sur différents systèmes.

Les données du descripteur DESCR_2 peuvent être stockées sur une mémoire M identique ou différente de la précédente mémoire.

La figue 2C représente, selon un mode de réalisation de l'invention, les composants du système de l'invention pour permettre la dernière étape de transformation des données du descripteur DESCR_1. Une fois générées, les données du descripteur DECSR_2 sont compilées grâce à la fonction COMPIL pour permettre la génération d'une librairie LIB de messages préconfigurés et la génération d'une fonction d'instanciation F_INST permettant d'instancier chaque message de la librairie LIB lorsque ces messages sont appelés ou sollicités lors d'une opération d'un opérateur.

La librairie de messages LIB est stockée dans une mémoire M du système et la fonction COMPIL peut être réalisée grâce à un calculateur du système. La mémoire M et le calculateur K permettant de réaliser ces fonctions peuvent être dédiés à ces applications. Selon un autre mode de réalisation, ils peuvent être les mêmes que ceux précédents décrits.

## Revendications

1. Procédé de génération d'un ensemble de données (ENS1) définissant un message (MES), **caractérisé en ce qu'**il comporte :
▪ Une définition d'un premier descripteur (DESCR_1) d'un ensemble de messages (MES), chaque message (MES) comportant un ensemble d'attributs comportant chacun un type réduit (TYP_RED), ledit descripteur (DESCR_1) décrivant également l'ensemble des types réduits (TYP_RED), chaque type réduit (TYP_RED) étant encodé à partir d'un type d'origine (TYP_ORI) ;
▪ Une transformation du premier descripteur (DESCR_1) en une librairie de messages préconfigurés (MES_H) définissant un référentiel donné (REF_H) ;
▪ Une instanciation d'un message (MES_H) du référentiel (REF_H) pour générer un ensemble de données sur une mémoire (M).

2. Procédé selon la revendication 1, **caractérisé en ce que** la définition du premier descripteur (DESCR_1) comprend un ensemble de règles définissant des gammes de valeurs d'un type réduit (TYP_RED), lesdites gammes de valeurs étant incluses dans les gammes de valeurs définissant un type d'origine (TYP_ORI).

3. Procédé selon la revendication 1, **caractérisé en ce qu'**un codage d'un type réduit (TYP_RED) comprend une réduction du nombre d'octets codant un type d'origine (TYP_ORI).

4. Procédé selon la revendication 1, **caractérisé en ce que** le codage d'un type réduit (TYP_RED) comprend la sélection d'un autre type que le type d'origine (TYP_ORI), ledit autre type comprenant un nombre d'octets inférieur au nombre d'octets du type d'origine (TYP_ORI).

5. Procédé selon la revendication 1, **caractérisé en ce que** le codage d'un type réduit (TYP_RED) comprend une troncature d'un type d'origine (TYP_ORI).

6. Procédé selon la revendication 1, **caractérisé en ce que** le codage d'un type réduit (TYP_RED) comprend une extraction d'une liste de valeurs d'un type d'origine (TYP_ORI).

7. Procédé selon la revendication 1, **caractérisé en ce que** la transformation du premier descripteur (DESCR_1) comprend :
▪ la génération d'un second descripteur (DESCR_2) ;
▪ la compilation du second descripteur (DESCR_2) pour générer :
o une librairie (LIB) de messages préconfigurés (MES_H) ;
o une fonction (F_INST) pour instancier un message sélectionné (MES).

8. Système de messagerie pour la mise en oeuvre du procédé selon l'une quelconque des revendications 1 à 7, **caractérisé en ce qu'**il comprend :
▪ au moins une mémoire (M) pour le stockage des données du premier descripteur (DESCR_1), des données du second descripteur (DESCR_2), des messages préconfigurés (MES_H) de la librairie (LIB) et des données générées par le procédé (MES) ;
▪ un calculateur (K) pour effectuer les opérations de transformation du premier descripteur (DESCR_1) en une librairie (LIB) de messages préconfigurés (MES_H) ;
▪ un calcul d'au moins une instance d'un message préconfiguré (MES).
